# EUROPEAN PATENT APPLICATION

(11) **EP 1 933 343 A1**
(43) Date of publication of application: **18.06.2008**
(21) Application number: 06025828.2
(22) Date of filing: 13.12.2006
(51) Int. Cl.: H01G 9/20

(54) **A method of preparing a porous semiconductor film on a substrate**

(71) Applicant: SONY DEUTSCHLAND GMBH, 10785 Berlin (DE); Sony Corporation, Tokyo 141-0001 (JP)
(72) Inventor: Dürr, Michael, Hedelfinger Strasse 61 (DE); Nelles, Gabriele, Hedelfinger Strasse 61 (DE); Yasuda, Akio, Hedelfinger Strasse 61 (DE); Suzuki, Yusuke, Shinagawa-ku (JP); Noda, Kazuhiro, Shinagawa-ku (JP)
(74) Representative: Appelt, Christian W.

(57) **Abstract**

A method of preparing a porous semiconductor film on a substrate comprising the steps:
a) preparing, on a first substrate, an adhesion layer capable of providing electrical and mechanical contact between a porous semiconductor layer attached to said adhesion Iayer arid said first substrate,
b) applying on a second substrate that is capable of withstanding temperatures >=300°C a spacer Iayer and applying a porous semiconductor layer on said spacer layer,
c) applying an assisting layer on said porous semiconductor Iayer, said assisting layer providing support for said porous semiconductor layer,
d) removing said spacer layer
e) transferring said porous semiconductor Iayer supported by said assisting layer onto said adhesion layer,
f) pressing said porous semiconductor Iayer onto said adhesion layer,
g) removing said assisting layer from said porous semiconductor Iayer, thereby obtaining said first substrate having as a porous semiconductor film said porous semiconductor layer attached thereon by way of said adhesion layer.

## Description

The present invention relates to a method of preparing a porous semiconductor film on a substrate, to a film produced by this method, to an electronic device including such film, and to uses of such film.

Single crystal solar cells show energy conversion efficiencies as high as ~ 25%. Where the Si-based crystals are no longer single crystals but polycrystalline, the highest efficiencies are in the range of ~ 18%, and with amorphous Si, the efficiencies are ~ 12%. Solar cells based on Si are, however, rather expensive to manufacture, even in the amorphous Si version. Therefore alternatives have been developed based on organic compounds and/or a mixture of organic and inorganic compounds, the latter type solar cells often being referred to as hybrid solar cells. Organic and hybrid solar cells have proved to be cheaper to manufacture, but seem to have yet comparably low efficiencies even when compared to amorphous Si cells. Due to their potential inherent advantages such as light weight, low-cost fabrication of large areas, environmentally friendly materials, or preparation on flexible substrates, efficient organic devices might prove to be technically and commercially useful "plastic solar cells". Recent progress in solar cells based on dye-sensitised nanocrystalline titanium dioxide (porous TiO₂) semiconductor and a liquid redox electrolyte demonstrates the possibility of high energy conversion efficiencies in organic materials. (B.O-Regan and M. Grätzel, Nature 353 (1991, 737).

Photoelectrochemical cells based on sensitisation of nanocrystalline TiO₂ by molecular dyes (dye-sensitized solar cells, DSSC) have attracted great attention since their first announcement as efficient photovoltaic devices (B. O'Regan and M. Grätzel, see above; WO 91/16719). One part of the ongoing investigations is to exploit the potential applicability of such cells on flexible substrates and with this the potential of fabricating flexible solar cells. One of the main challenges to be solved prior to the successful introduction of such flexible DSSC is the restricted range of temperature applicable to plastic substrates. Mostly, the used TiO₂ nanoparticles are brought into good electrical contact by the application of temperatures as high as 450° C. Such processes are not applicable on flexible plastic substrates which limits so far the efficiency of cells made of these substrates. With respect to other sintering methods, the most promising way to fabricate flexible DSSCs has been so far to apply high pressures to the TiO₂ layer [H. Lindström, et al, A new method for manufacturing nanostructured electrodes on plastic substrates, Nano Lett. 1, 97 (2001); H. Lindström, et al, Method for manufacturing nanostructured thin film electrodes. WO 00/72373; H. Lindström, et al, A new method to make dye-sensitized nanocrystalline solar cells at room temperature, J. Photochem. Photobiol. A 145, 107 (2001); G. Boschloo, et al, Optimization of dye-sensitized solar cells prepared by compression method, J. Photochem. Photobiol. A 148, 11 (2002).]. Additionally, chemical sintering has been applied with minor success [D. Zhang, et al, Low-temperature fabrication of efficient porous titania photoelectrodes by hydrothermal crystallization at the solid/gas interface, Adv. Mater. 15, 814 (2003); D. Zhang, et al, Low temperature synthesis of porous nanocrystalline TiO2 thick film for dye-sensitized solar cells by hydrothermal crystallization, Chem. Lett. 9, 874 (2002).]. Combination of both methods, i.e. temperature sintering and chemical sintering leads also only to minor improvements [S. A. Hague, et al, Flexible dye-sensitized nanocrystalline semiconductor solar cells, Chem. Comm. 24, 3008 (2003)].

WO2005/104153 A1 discloses a method of producing a porous semiconductor film on a substrate wherein a pre-sintered layer is lifted off a preparation substrate and transferred onto a second arbitrary substrate of choice, either flexible or rigid, i.e. the target substrate. The process does not require high temperatures, as far as the target substrate is concerned, since the sintering of the semiconductor layer can be performed on the preparation substrate which is able to withstand high temperatures, whereas the second, i.e. target substrate does not necessarily have to have this quality.

As in all previously described methods for producing porous semiconductor layers, the porous layers used for the fabrication of dye-sensitized solar cells generally have a thickness in the micrometer range. The layers are brittle, and the transfer of such layers from one substrate to another is difficult to achieve without damaging or actually even destroying the layers. Consequently, the most developed of the technique so far, the aforementioned lift-off technique, was restricted to the preparation of layers the area of which did not exceed 1-2 cm². Furthermore the lift-off-technique described in the prior art implied that each "patch" of the porous semiconductor layer has to be transferred separately from the preparation substrate to the target substrate and therefore makes this procedure labor intensive and cost intensive.

Accordingly, it was an object of the present invention to provide for a method that allows the preparation of porous semiconductor layers on arbitrary substrates over larger areas. Furthermore, it was an object of the present invention to provide for a method that is amenable to automation and high throughput applications.

The objects of the present invention are solved by a method of preparing a porous semiconductor film on a substrate, comprising the steps:
a) preparing, on a first substrate, an adhesion layer capable of providing electrical and mechanical contact between a porous semiconductor layer attached to said adhesion layer and said first substrate,
b) applying on a second substrate that is capable of withstanding temperatures ≥ 300°C, a spacer layer, and applying a porous semiconductor layer on said spacer layer,
c) applying an assisting layer on said porous semiconductor layer, said assisting layer providing support for said porous semiconductor layer,
d) removing said spacer layer
e) transferring said porous semiconductor layer supported by said assisting layer onto said adhesion layer
f) pressing said porous semiconductor layer onto said adhesion layer,
g) removing said assisting layer from said porous semiconductor layer, thereby obtaining said first substrate having as a porous semiconductor film said porous semiconductor layer attached thereon by way of said adhesion layer.

In one embodiment steps a) and b) are performed in the order ab or ba or concomitantly with each other or in a temporally overlapping manner.

In one embodiment steps f) and g) are performed in the order fg or gf, or concomitantly with each other or in a temporally overlapping manner. As a result of performing steps f and g in any of the aforementioned orders, a mechanical and electrical contact is established between said porous semiconductor layer attached to said adhesion layer and said first substrate.

In one embodiment said assisting layer is applied on said porous semiconductor layer by a process selected from casting, spin coating, drop casting, ink-jet printing, screen printing, doctor blading, spraying, lamination.

In one embodiment the contact area between the assisting layer and the porous semiconductor layer is equal to the whole surface area of the porous semiconductor layer. In another embodiment the contact area between said assisting layer and said porous semiconductor layer is smaller than the whole surface area of the porous semiconductor layer, e.g. only selective contact areas. In yet another embodiment, the contact area between the assisting layer and the porous semiconductor layer is equal to the whole surface area of the porous semiconductor layer, but the assisting layer has a larger surface area than the porous semiconductor layer and extends beyond the sides of the porous semiconductor layer.

Preferably, said assisting layer is made of a polymeric material, wherein, more preferably, said assisting layer is applied on said porous semiconductor layer as a composition comprising polymer precursors and, upon application on said porous semiconductor layer, said composition is cured to form said assisting layer made of said polymeric material.

In another embodiment said assisting layer is applied on said porous semiconductor layer as a polymer dissolved in an appropriate solvent, and thereafter said solvent is evaporated.

In one embodiment said polymeric material is selected from the group comprising poly(methyl methacrylate) (PMMA), poly(dimethylsiloxane) (PDMS), silicone rubbers, e.g. Sylgard^{®}, Surlyn, epoxy resin, polyurethane (PU), poly(acrylonitrile-butadiene-styrene) (ABS), cellulose acetate, polystyrene (PS), polyethylene (PE), poly(vinylchloride) (PVC), polyimide (PI), cross-linked phenolformaldehyde polymer resins (Novolac^{®}).

Preferably, said polymeric material is a solid elastomer or a thermoplastic polymer.

In one embodiment, said assisting layer is a foil.

In one embodiment, the adhesion between said assisting layer and said porous layer is based on electrostatic interactions, van-der-Waals interactions, covalent binding, ionic binding, or vacuum supported.

In one embodiment said assisting layer is reinforced by an additional substrate on said assisting layer, such as a glass substrate.

Preferably, said assisting layer consists of one, two or more different layers at least one of which is made of a polymeric material.

In one embodiment said polymeric material has a Young's modulus in the range of from 1 MPa to 10 GPa, preferably from 3 MPa to 30 MPa.

In one embodiment in step e), said assisting layer is removed from said porous semiconductor layer by exposure of said assisting layer to one or several of the following: UV light, solvent, UV light plus solvent, plasma, high / low temperature, base, such as NaOH, acid.

In one embodiment said porous semiconductor layer, after having been applied on said spacer layer in step b), is a non-compressed layer of semiconductor particles, wherein, preferably, said semiconductor particles have sizes in the range of from about 10 nm to about 1000 nm, preferably from about 10 nm to about 500 nm.

In one embodiment step e) comprises the steps:
ea) separating said porous semiconductor layer from said second substrate, and,
eb) optionally dyeing said porous semiconductor layer, preferably using a dye useful for dye-sensitized solar cells, and
ec) transferring said porous semiconductor layer without said second substrate and without said spacer layer, but supported by said assisting layer, onto said adhesion layer.

Preferably, step b) comprises the steps:
ba) applying said spacer layer on said second substrate by a method selected from evaporation, sputtering, electrodeposition, self-assembly, electrostatic layer-by-layer assembly, spraying and printing techniques like screen printing, doctor blading, drop casting, spin coating, ink-jet printing.
bb) applying said porous semiconductor layer on said spacer layer by a method selected from printing, in particular screen printing, doctor blading, drop casting, spin coating, ink-jet printing, electrostatic layer-by-layer assembly and spraying,
bc) sintering said porous semiconductor layer, and, optionally,
bd) dyeing said porous semiconductor layer, preferably using a dye useful for dye-sensitized solar cells.

In one embodiment in step a) said adhesion layer is prepared on said first substrate by a method selected from printing, in particular screen printing and/or ink-jet-printing, doctor blading, drop casting, spin coating, and spraying.

Preferably, step ea) comprises a lifting-off of said porous semiconductor layer from said second substrate, wherein, more preferably, the lifting-off occurs by removal of said spacer layer and said second substrate or parts of it from said porous semiconductor layer.

In one embodiment said spacer layer is organic, inorganic, metal, preferably gold, or a combination thereof, wherein, preferably, said spacer layer is made of gold, and removal thereof occurs by oxidation, e.g. by treatment with an oxidizing agent, for example a strong acid, or a redox couple, e.g. iodine/iodide.

In one embodiment said spacer layer is removed in step d) by chemical and/or physical methods, thereby allowing the lifting-off of said porous semiconductor layer, wherein, preferably, said spacer layer is organic, inorganic, metal, preferably gold or a combination thereof, and wherein, more preferably, said spacer layer is made of metal, preferably gold, and removal thereof occurs by oxidation, e.g. by treatment with an oxidizing agent, for example a strong acid, or a redox couple, e.g. iodine/iodide.

In one embodiment said removal is performed by physical methods, e.g. peeling, and/or chemical methods, e.g. etching and/oxidation.

Preferably said transfer of step e) is performed, while said porous semiconductor layer is in a wet or dry state, wherein, more preferably, said transfer is achieved by a roll-to-roll-technique.

In one embodiment said sintering of step bc) occurs at a temperature in the range of from 300°C -1000°C, preferably > 350°C, more preferably > 380°C, most preferably > 400°C.

Preferably, said pressing of said porous semiconductor layer onto said adhesion layer in step e) occurs with a pressure in the range of from 1 to 100 x 10³ N/cm², preferably from 1 - 30 x 10³ N/cm², and more preferably from 10 - 30 x 10³ N/cm².

In one embodiment said adhesion layer is a layer of semiconductor particles, preferably oxide particles, more preferably TiO₂-particles, in particular anatase-TiO₂ particles.

It is clear to someone skilled in the art that a wide variety of semiconductor particles can be used for practicing the present invention. Examples of these are, without being limited thereto: TiO₂, SnO₂, ZnO, Nb₂O₅, ZrO₂, CeO₂, WO₃, SiO₂, Al₂O₃, CuAlO₂, SrTiO₃ and SrCu₂O₂, or a complex oxide containing several of these oxides.

In one embodiment, said porous semiconductor layer is a layer of semiconductor particles, preferably oxide particles, more preferably TiO₂-particles, in particular anatase-TiO₂-particles.

In one embodiment said porous semiconductor layer comprises semiconductor particles having sizes in the range of from about 10 nm to about 1000 nm, preferably from about 10 nm to about 100 nm, or mixtures of semiconductor particles having different ranges of size, e.g. one type of particles having sizes in the range from about 10 nm to about 30 nm and another type of particles having sizes in the range of from about 200 nm to about 400 nm.

In one embodiment said porous semiconductor layer has a porosity in the range of from 30% to 80%, as measured by nitrogen adsorption techniques. In this context and as used herein, a film having x% porosity means that x% of the total volume occupied by the film are void space.

Preferably, said porous semiconductor layer is a composite layer comprising a first sublayer and a second sublayer adjacent to said first sublayer, wherein said first sublayer comprises spherical nanoparticles and said second sublayer comprises elongated rod-like nanoparticles, wherein, more preferably, said spherical nanoparticles have a size in the range of from about 10 nm to about 1000 nm, more preferably about 10 nm to about 100 nm, and said elongated rod-like particles have an average length along their longest dimension of about 10 nm to about 1000 nm, preferably about 50 nm to about 200 nm, wherein, preferably, the ratio between the longest axis and shortest axis of the elongated rod-like particles is 2 or larger, and, more preferably, between 2 and 10.

In one embodiment in said porous semiconductor film on a substrate, said first sublayer is facing said adhesion layer and said second sublayer is further apart from said adhesion layer.

Preferably, said first and said second sublayers have a thickness in the range of from 1 µm to 25 µm each.

In one embodiment said second substrate is a substrate capable of withstanding temperatures in the range from 300 - 1000 °C, preferably > 350°C, more preferably > 380 °C, most preferably > 400°C, wherein, preferably, said second substrate is made of glass or metal, preferably stainless steel.

In one embodiment said porous semiconductor layer has a thickness in the range of from about 1 µm to about 50 µm.

In one embodiment said adhesion layer is a layer of semiconductor particles having sizes in the range of from about 10 nm to about 100 nm, preferably about 10 nm to about 50 nm, more preferably about 10 nm to about 20 nm.

In one embodiment said adhesion layer has a thickness in the range of from about 10 nm to about 1 µm, preferably a thickness < 500 nm, more preferably ≤ 100 nm.

In one embodiment said first substrate is made of flexible material.

In one embodiment, said flexible material is incapable of withstanding sintering procedures at temperatures > 250°C.

The objects of the present invention are also solved by a porous semiconductor film, produced by the method according to the present invention, which, preferably, does not lose its capability of functioning as a photoactive layer when used in a photovoltaic cell and when covering an area > 2 cm² in said photovoltaic cell.

The objects of the present invention are also solved by an electronic device comprising a porous semiconductor film according to the present invention.

Preferably, the electronic device according to the present invention is a solar cell or a sensor device, preferably having at least one, more preferably two flexible substrates, most preferably two plastic, flexible or paper substrates, as a result of which said electronic device, preferably said solar cell or sensor device may be curved or bent or form stable.

Preferably, the electronic device according to the present invention is a solar cell or a sensor device, preferably having at least one, more preferably two plastic substrates.

The objects of the present invention are also solved by the use of the method according to the present invention for producing an electronic device, in particular a solar cell.

The objects of the present invention are also solved by the use of the porous semiconductor film according to the present invention in an electronic device, preferably a solar cell.

The term "assisting layer", as used herein, is meant to refer to a layer that aids in transferring the porous semiconductor layer from the second substrate, i.e. the "preparation substrate" to the first substrate, i.e. the "target substrate". The assisting layer provides support for the porous semiconductor layer, especially during the transfer from one substrate to the other.

If, in the context of the present application reference is made to a method comprising a sequence of steps denoted by letters a, b, c etc. this is usually meant to mean that the steps are performed in the sequence as the letters occur in the alphabet. If the steps are to be performed in a different manner hereto, e.g. in reverse order or concomitantly, this is usually indicated explicitly.

The inventors have surprisingly found that by using an assisting layer on the porous semiconductor layer, it is possible to stabilize the porous semiconductor layer especially during the transfer step. The assisting layer may be chosen appropriately so as to have a low interfacial energy and/or to have a reversible adhesion to the porous semiconductor layer. Moreover, the assisting layer may be chosen such that it has chemical stability during the transfer process whilst it may subsequently be removed from the porous semiconductor layer after the transfer step or after application of high pressure by exposure to chemicals, solvents, UV-light or high/low temperature. Moreover, the interfacial properties of the assisting layer may be changed depending on the type of material that is used for its preparation. For example if the assisting layer is made of a polymeric material, its interfacial properties can be changed by changing the prepolymers by including additives with functional units, or by a plasma treatment or by the inclusion of self-assembled monolayers (SAMs) with functional endgroups. The method according to the present invention using an assisting layer enables the preparation of porous semiconductor layers on a substrate over an area of several tens cm² to several hundreds of cm². The method according to the present invention using an assisting layer enables further a continuous transfer, i.e. in a roll-to-roll process and is thus amenable to industrial production.

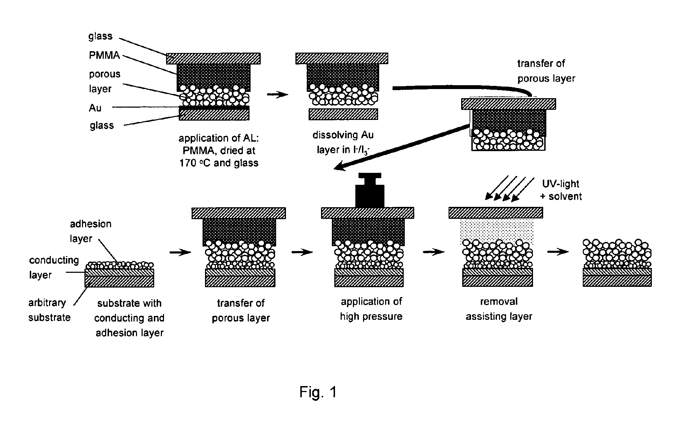

An exemplary description of the assisting-layer lift-off (ALLO) process according to the present invention is depicted in figure 1, exemplified for PMMA on glass as the assisting layer (AL). Generally, the process may be described as follows: a porous layer is applied on a heat-resistant substrate which is covered by a spacer layer. After sintering the porous semiconductor layer, the assisting layer is applied on top of the porous layer. The spacer layer underneath the porous layer is then removed, and thereafter, the porous layer, stabilized by the assisting layer, can be lifted-off the substrate and transferred to the target substrate of choice. This target substrate of choice is covered by a conducting material and an adhesion layer, the latter of which enables a good mechanical and electrical contact between the transferred porous layer and the conducting material. The contact may be increased by applying pressure on the transferred porous layer with the pressure having the order of several 10 kN/cm² to several 100 kN/cm², preferably 10 - 30 kN. Thereafter, the assisting layer is removed by an appropriate process, such as dissolving in an appropriate solvent, exposure to UV-light, striping or pull off, exposure to chemicals, such as acid or base or a combination of any of the foregoing. Exposure to base is particularly useful if the adhesion is mediated via functional units or groups, like -COOH, -OSO₃H, -OPO₃H₂. After removal, the dye-sensitized solar cell (DSSC) can be further prepared as in a common DSSC fabrication process, i.e. dyeing the porous layer, applying electrolyte and a counter electrode.

In the following, reference is made to the figures, wherein
Figure 1 shows a scheme of the assisting-layer lift-off process according to the present invention, which, in the figure is exemplarily based on a PMMA/glass layer as assisting layer.
Figure 2 shows the J-V characteristics of an embodiment of an assisting-layer lift-off (ALLO) cell in accordance with the present invention and cells based on an adhesion layer only, i.e. cells with a similar adhesion layer but no additional porous semiconductor layer.
Figure 3 shows a table illustrating the photovoltaic data of an ALLO-cell and the data of cells based on an adhesion layer only. V_{oc} is the open circuit voltage, J_{sc} is the short circuit current density, FF is the fill factor, and Eff is the efficiency.

Moreover, reference is made to the following example which is given to illustrate, not to limit the present invention.

### Example

A porous TiO₂ layer (15 µm) is applied by screen printing on a 30-nm-gold-covered glass substrate. After sintering the porous layer at 500 °C for 30 min, the assisting layer is applied: PMMA is applied by spin coating and covered by a glass substrate. The solvent is then evaporated at 170 °C (10 min). The gold layer is then removed by dissolving in electrolyte (iodine (200 mM) / iodide (2 M) in acetonitrile). After washing the porous layer in acetonitrile and ethanol, it is applied on the second substrate, i.e. ITO on PET, or FTO on glass. The adhesion layer consists of a porous layer with a thickness between 100 nm and 1 µm. It should be as thin as possible but thick enough to ensure good contact to the transferred porous layer. Contact between the adhesion and the transferred layer is strengthened by the application of pressure p = 30 kN/cm² and / or temperature. After this, the PMMA layer is dissolved in acetonitrile after irradiation with UV light. Rinsing the porous layer in acetonitrile and ethanol completes the removal process and the DSSC is further assembled as described earlier: red dye molecules (N3 bis-TBA) are attached as a monolayer to the TiO₂ via self-assembling out of a solution in ethanol (0.3 mM). The coloured porous layer is filled with electrolyte (acetonitrile with iodine/iodide (0.2 M/2 M) serving as redox-couple). A 15-µm-thick bulk layer of the same electrolyte bridges the gap between porous layer and a flat, smooth platinum film (50 nm) applied on a substrate of any kind. To avoid direct contact between the TiO₂ layer and the platinum counter electrode, spacers, e.g. balls made of glass or spacer foil, are introduced between the two electrodes.

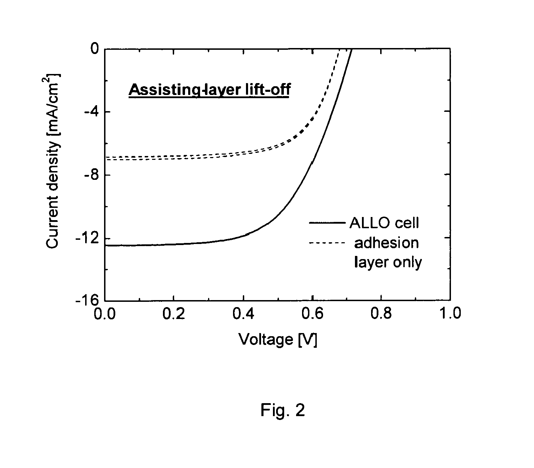

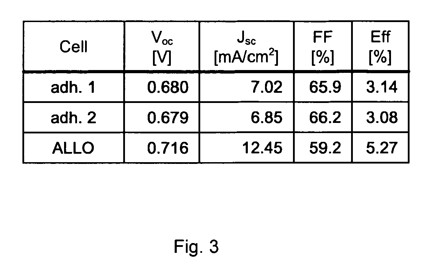

A comparison of current-voltage-characteristics of DSSC fabricated by the assisting-layer lift-off process and the DSSC using the adhesion layer only is shown in Fig. 2 for illumination by 100mW/cm² of simulated sun light. One can easily see that the photovoltaic properties of the ALLO cells by far exceed those of the reference cells (compare Table 1 in Fig. 3). This demonstrates the successful application of the ALLO concept.
The features of the present invention disclosed in the specification, the claims and/or in the accompanying drawings, may, both separately, and in any combination thereof, be material for realizing the invention in various forms thereof.

## Claims

1. A method of preparing a porous semiconductor film on a substrate, comprising the steps:
a) preparing, on a first substrate, an adhesion layer capable of providing electrical and mechanical contact between a porous semiconductor layer attached to said adhesion layer and said first substrate,
b) applying on a second substrate that is capable of withstanding temperatures≥ 300 °C, a spacer layer, and applying a porous semiconductor layer on said spacer layer,
c) applying an assisting layer on said porous semiconductor layer, said assisting layer providing support for said porous semiconductor layer,
d) removing said spacer layer,
e) transferring said porous semiconductor layer supported by said assisting layer onto said adhesion layer
f) pressing said porous semiconductor layer onto said adhesion layer,
g) removing said assisting layer from said porous semiconductor layer, thereby obtaining said first substrate having as a porous semiconductor film said porous semiconductor layer attached thereon by way of said adhesion layer.

2. The method according to claim 1, wherein steps a) and b) are performed in the order ab or ba or concomitantly with each other or in a temporally overlapping manner.

3. The method according to any of claims 1-2, wherein said assisting layer is applied on said porous semiconductor layer by a process selected from casting, spin coating drop casting, spraying, ink-jet printing, screen printing, doctor blading and lamination.

4. The method according to any of the foregoing claims, wherein said assisting layer is made of a polymeric material.

5. The method according to claim 4, wherein said assisting layer is applied on said porous semiconductor layer as a composition comprising polymer precursors and, upon application on said porous semiconductor layer, said composition is cured to form said assisting layer made of said polymeric material.

6. The method according to claim 4, wherein said assisting layer is applied on said porous semiconductor layer as a polymer dissolved in an appropriate solvent, and thereafter said solvent is evaporated.

7. The method according to any of claims 4-6, wherein said polymeric material is selected from the group comprising poly(methyl methacrylate) (PMMA), poly(dimethylsiloxane) (PDMS), silicone rubbers, e.g. Sylgard^{®}, Surlyn, epoxy resin, polyurethane (PU), poly(acrylonitrile-butadiene-styrene) (ABS), cellulose acetate, polystyrene (PS), polyethylene (PE), poly(vinylchloride)(PVC), polyimide (PI), cross-linked phenolformaldehyde polymer resins (Novolac^{®}).

8. The method according to any of claims 4-7, wherein said polymeric material is a solid elastomer or a thermoplastic polymer.

9. The method according to the foregoing claims, wherein said assisting layer is reinforced by an additional substrate on said assisting layer, such as a glass substrate.

10. The method according to any of claims 4-9, wherein said assisting layer consists of one, two or more different layers at least one of which is made of a polymeric material.

11. The method according to any of claims 4-10, wherein said polymeric material has a Young's modulus in the range of from 1 MPa to 10 GPa, preferably from 3 MPa to 30 MPa.

12. The method according to any of the foregoing claims, wherein, in step g), said assisting layer is removed from said porous semiconductor layer by exposure of said assisting layer to one or several of the following: UV light, solvent, UV light plus solvent, plasma, high or low temperature, base, such as NaOH, acid.

13. The method according to any of the foregoing claims, wherein said porous semiconductor layer, after having been applied on said spacer layer in step b), is a non-compressed layer of semiconductor particles.

14. The method according to claim 13, wherein said semiconductor particles have sizes in the range of from about 10 nm to about 1000 nm, preferably from about 10 nm to about 500 nm.

15. The method according to any of the foregoing claims, wherein step e) comprises the steps:
ea) separating said porous semiconductor layer from said second substrate, and,
eb) optionally dyeing said porous semiconductor layer, preferably using a dye useful for dye sensitized solar cells, and
ec) transferring said porous semiconductor layer without said second substrate and without said spacer layer, but supported by said assisting layer, onto said adhesion layer.

16. The method according to any of the foregoing claims, wherein step b) comprises the steps:
ba) applying said spacer layer on said second substrate by a method selected from evaporation, sputtering, electrodeposition, self-assembly, electrostatic layer-by-layer assembly, spraying and printing techniques like screen printing, ink-jet printing, doctor blading, drop casting, spin coating, and spraying,
bb) applying said porous semiconductor layer on said spacer layer by a method selected from printing, in particular screen printing, doctor blading, drop casting, spin coating, ink-jet printing, electrostatic layer-by-layer assembly and spraying,
bc) sintering said porous semiconductor layer, and, optionally,
bd) dyeing said porous semiconductor layer, preferably using a dye useful for dye sensitized solar cells.

17. The method according to any of the foregoing claims, wherein in step a) said adhesion layer is prepared on said first substrate by a method selected from printing, in particular screen printing and/or ink-jet-printing, doctor blading, drop casting, spin coating, and spraying.

18. The method according to any of claims 15-17, wherein step ea) comprises a lifting-off of said porous semiconductor layer from said second substrate.

19. The method according to claim 18, wherein the lifting-off occurs by removal of said spacer layer and said second substrate or parts of it from said porous semiconductor layer.

20. The method according to any of claims 18-19, wherein said spacer layer is removed by chemical and/or physical methods and, in step d), is removed by chemical and/or physical methods, thereby allowing the lifting-off of said porous semiconductor layer.

21. The method according to claim 20 wherein said spacer layer is organic, inorganic, metal, preferably gold or a combination thereof.

22. The method according to claim 21, wherein said spacer layer is made of metal, preferably gold, and removal thereof occurs by oxidation, e.g. by treatment with an oxidizing agent, for example a strong acid, or a redox couple, e.g. iodine/iodide.

23. The method according to any of claims 19-22, wherein said removal is performed by physical methods, e.g. peeling, and/or chemical methods, e.g. etching and/oxidation.

24. The method according to any of the foregoing claims, wherein said transfer of step e) is performed, while said porous semiconductor layer is in a wet or dry state.

25. The method according to claim 24, wherein said transfer is achieved by a roll-to-roll-technique.

26. The method according to any of claims 16-25, wherein said sintering of step bc) occurs at a temperature in the range of from 300°C - 1000°C, preferably > 350°C, more preferably > 380°C, most preferably > 400°C.

27. The method according to any of the foregoing claims, wherein said pressing of said porous semiconductor layer onto said adhesion layer in step e) occurs with a pressure in the range of from 1 to 100 x 10³ N/cm², preferably from 1-30 x 10³ N/cm², and more preferably from 10-30 x 10³ N/cm².

28. The method according to any of the foregoing claims, wherein said adhesion layer is a layer of semiconductor particles, preferably oxide particles, more preferably TiO₂-particles, in particular anatase-TiO₂ particles.

29. The method according to any of the foregoing claims, wherein said porous semiconductor layer is a layer of semiconductor particles, preferably oxide particles, more preferably TiO₂-particles, in particular anatase-TiO₂-particles

30. The method according to any of the foregoing claims, wherein said porous semiconductor layer comprises semiconductor particles having sizes in the range of from about 10 nm to about 1000 nm, preferably from about 10 nm to about 100 nm, or mixtures of semiconductor particles having different ranges of size, e.g. one type of particles having sizes in the range from about 10 nm to about 30 nm and another type of particles having sizes in the range of from about 200 nm to about 400 nm.

31. The method according to any of the foregoing claims, wherein said porous semiconductor layer has a porosity in the range of from 30% to 80%, as measured by nitrogen adsorption techniques.

32. The method according to any of the foregoing claims, wherein said second substrate is a substrate capable of withstanding temperatures in the range from 300 °C to 1000 °, preferably > 350°C, more preferably > 380 °C, most preferably > 400 °C.

33. The method according to claim 32, wherein said second substrate is made of glass or metal, preferably stainless steel.

34. The method according to any of the foregoing claims, wherein said porous semiconductor layer has at thickness in the range of from about 1 µm to about 50 µm.

35. The method according to any of the foregoing claims, wherein said adhesion layer is a layer of semiconductor particles having sizes in the range of from about 10 mn to about 100 nm, preferably about 10 nm to about 50 nm, more preferably about 10 nm to about 20 nm.

36. The method according to any of the foregoing claims, wherein said adhesion layer has a thickness in the range of from about 10 nm to about 1 µm, preferably a thickness < 500 nm, more preferably ≤ 100 nm.

37. The method according to any of the foregoing claims, wherein said first substrate is made of flexible material.

38. A porous semiconductor film, produced by the method according to any of claims 1-37 , which, preferably, does not lose its capability of functioning as a photoactive layer when used in a photovoltaic cell and when covering an area > 2 cm² in said photovoltaic cell.

39. An electronic device comprising a porous semiconductor film according to claim 38.

40. Electronic device according to claim 39, which is a solar cell or a sensor device,preferably having at least one, more preferably two flexible substrates, even more preferably two plastic, flexible or paper substrates, as a result of which said electronic device, preferably said solar cell or sensor device may be curved or bent or form stable.

41. Use of the method according to any of claims 1-37 for producing an electronic device, in particular a solar cell.

42. Use of the porous semiconductor film according to claim 38 in an electronic device, preferably a solar cell.
